# FASCICULE DE BREVET EUROPEEN

(11) **EP 1 701 602 B1**
(45) Date de publication et mention de la délivrance du brevet: **26.12.2007**
(21) Numéro de dépôt: 06290388.5
(22) Date de dépôt: 09.03.2006
(51) Int. Cl.: H05K 5/02, H05K 7/18, B65D 19/00, B65D 19/44, B65D 19/26

(54) **Agencement et procédé de conditionnement d'une baie informatique, baie informatique et palette de transport à cet effet**
Anordnung und Verfahren zum Verpacken eines Gestells für Computer, Gestell für Computer und Palette für dieses Gestell
System and method for packaging a rack for computer, rack for computer and transport pallet for this rack

(30) Priorité: 11.03.2005 FR 0502428
(43) Date de publication de la demande: 13.09.2006
(73) Titulaire: Bull S.A.S., 78340 Les Clayes sous Bois (FR)
(72) Inventeur: Mollard, Emmanuel, 92000 Nanterre (FR); Coutancier, Lionel, 28210 Croisilles (FR)
(74) Mandataire: Debay, Yves

(56) Documents cités:
- EP-A- 0 897 875
- FR-A- 2 816 594
- FR-A- 2 829 467
- US-A- 5 457 849
- US-B1- 6 636 418

## Description

La présente invention est relative au domaine des baies informatiques de type haute densité des centres de données, des salles réseau et des armoires de câblage. L'invention concerne plus particulièrement un agencement et un procédé de conditionnement utilisé dans la palettisation et la dépalettisation d'une baie informatique. Une baie informatique et une palette de transport spécifiques à cet agencement original sont également l'objet de la présente invention.

Dans les procédés classiques actuels, la baie informatique est amenée via ses roulettes sur le plateau supérieur de la palette par une rampe de chargement solidaire ou rapportée à la palette. La baie est ensuite livrée au client puis dépalettisée sur site par le même procédé.

Bien qu'à l'heure actuelle, ces systèmes soient faciles à mettre en oeuvre, ils présentent tout de même quelques limites. La procédure de dépalettisation qui consiste à descendre la baie de sa palette révèle quelques lacunes relatives à la sécurité des opérateurs mais également à la protection du matériel. Deux voire trois opérateurs sont nécessaires pour assurer la descente d'une baie de sa palette. En effet, cette dernière peut peser jusqu'à 1200 kg et ses dimensions ne lui permettent pas d'être manipulée par une seule personne.

Des phénomènes inopinés, liés à la dynamique, peuvent entraîner la chute de la baie. Pour n'en citer que quelques-uns : rampes instables, baie qui se déplace en diagonale et sort de sa trajectoire, baie qui se met à accélérer car difficile à maintenir à cause de sa masse et de ses dimensions.

Il faut aussi remarquer que la hauteur de l'ensemble baie palettisée et emballée est limitée par la hauteur de passage sous le cadre supérieur des portes. Ceci restreint par conséquent la hauteur utile de la baie alors que la tendance est de chercher à la maximiser. Cette hauteur utile est généralement exprimée en nombre total d'unités U issues du standard EIA-310-D, cette unité permettant le repérage et le positionnement vertical des équipements informatiques dans une baie [1 U=44,45 mm].

Concrètement, du fait d'une hauteur de porte limité à environ 2 mètres, une baie dont la hauteur utile est supérieure à 36 U ne peut pas être amenée dans la salle de fonctionnement avec sa palette et son emballage. Celle-ci est en général dépalettisée à l'extérieur des bâtiments. Plusieurs inconvénients se présentent alors : le matériel est déballé quel que soit le temps (pluie, vent, neige...) et surtout avant d'avoir atteint la température ambiante de la salle d'accueil ; la baie (1200kg maxi) après dépalettisation, est transportée (en utilisant ses propres roulettes) jusqu'à la salle avec certaines difficultés dues à la nature du revêtement et à la déclivité du sol. Ces difficultés sont amoindries avec l'utilisation d'un chariot de manutention qui est beaucoup plus souple d'utilisation.

Toutefois, l'utilisation d'un chariot à l'intérieur de bâtiments ne permet pas l'emploi de baies informatiques de hauteur élevée.

La présente invention a pour objet de pallier un ou plusieurs des inconvénients de l'art antérieur, en proposant un agencement de conditionnement adapté au transport tout en permettant de maximiser la hauteur de baie proprement dite.

A cet effet, l'invention concerne un agencement de conditionnement d'une baie informatique, du type transportable à l'aide d'un appareil de levage, comprenant une palette de transport et une baie informatique, la baie informatique étant du type associable à des roulettes s'étendant verticalement d'une première distance déterminée par rapport à au moins une face inférieure de la baie informatique, caractérisé en ce que la baie informatique est rendue solidaire de la palette de transport par deux moyens d'ancrage de la baie informatique, répartis sous la face inférieure de la baie informatique, de part et d'autre d'un plan médian vertical, ladite palette comportant deux modules latéraux et au moins un moyen support intermédiaire du type séparable du reste de la palette et permettant de raccorder les modules latéraux, un premier des modules latéraux de la palette incluant des moyens de fixation amovible au premier moyen d'ancrage et un second des modules latéraux de la palette incluant des moyens de fixation amovible au second moyen d'ancrage, les moyens de fixation des modules latéraux et lesdits moyens d'ancrage étant agencés en vis-à-vis pour maintenir en position horizontale la face inférieure de la baie informatique, de sorte que le dessus de la palette soit espacé de la face inférieure de la baie informatique d'une seconde distance déterminée strictement inférieure à la dite première distance déterminée.

Ainsi, l'invention propose avantageusement un type de palette et un type de baie spécifiques, permettant de gagner en hauteur utile de la baie informatique, en minimisant l'espace entre la palette de transport et la face inférieure de la baie informatique. L'invention permet de supprimer le supplément de hauteur lié aux roulettes de la baie informatique et propose l'utilisation d'une palette de transport à modules séparables qui facilitent l'opération de dépalettisation. La baie informatique peut en effet être maintenue surélevée par un engin élévateur et aisément désolidarisée des modules de la palette.

Selon une caractéristique de l'invention, l'agencement comporte au moins deux dispositifs amovibles à roulettes dotés chacun d'un organe de coopération prévu pour se fixer à un des moyens d'ancrage de la baie informatique.

Selon une caractéristique, les moyens d'ancrage sous la baie informatique comprennent des glissières respectives, les glissières incluant des rails horizontaux, les deux modules latéraux comprenant chacun une surface supérieure équipée d'au moins un plateau parallèle à ladite surface supérieure, plateau sous lequel sont formées des gorges ou rainures adjacentes à ladite surface supérieure pour recevoir l'extrémité d'un rail des glissières.

Selon une caractéristique, les plateaux des modules latéraux sont en contact direct avec la face inférieure de la baie informatique.

Selon une caractéristique, les moyens d'ancrage comprennent des glissières parallèles adaptées pour recevoir de manière interchangeable soit les modules latéraux de la palette de transport, soit des dispositifs amovibles à roulettes.

Ainsi, la baie informatique désolidarisée de sa palette et maintenue surélevée par un engin de manutention peut facilement recevoir les dispositifs à roulettes qui se substituent aux modules latéraux de la palette.

Selon une autre particularité, les dispositifs amovibles à roulettes sont dotés chacun d'au moins deux roulettes et d'au moins deux vérins de positionnement au sol ajustables verticalement.

Selon une autre particularité, le moyen support intermédiaire et les modules latéraux de la palette comportent chacun une face supérieure pour former dans un même plan horizontal le dessus de la palette, ledit moyen support intermédiaire comprenant en outre au moins un tasseau formé sur sa face supérieure pour soutenir ladite face inférieure de la baie informatique.

Selon une autre particularité, la seconde distance déterminée est comprise entre 0,4 et 4 cm.

Ainsi, la perte de hauteur immédiatement en dessous de la baie informatique est considérablement réduite.

Selon une autre particularité, la palette comporte des moyens de blocage en position de la baie répartis sur chacun des modules latéraux.

Selon une autre particularité, ledit moyen support intermédiaire est de moindre épaisseur par rapport à l'épaisseur des modules latéraux, de façon à laisser un espacement entre le niveau le plus bas de la palette et la partie la plus basse du moyen support intermédiaire, cet espacement facilitant la séparation du moyen support intermédiaire par rapport au reste de la palette.

Un autre objet de l'invention est de proposer une structure de baie informatique permettant de minimiser les difficultés de transport et de coopérer étroitement avec une palette de transport.

A cet effet, l'invention concerne une baie informatique du type associable à des roulettes disposées sous au moins une face inférieure de la baie informatique et spécifiquement adaptée pour constituer avec une palette de transport l'agencement selon l'invention, caractérisée en ce qu'elle comporte :
- au moins deux dispositifs amovibles à roulettes ; et
- deux moyens d'ancrage répartis sous la face inférieure de la baie informatique, de part et d'autre d'un plan médian vertical, les moyens d'ancrage comprenant des glissières respectives parallèles adaptées à la fois pour recevoir de façon interchangeable les dispositifs amovibles à roulettes et des moyens de fixation amovible d'une palette de transport, de façon à minimiser l'espacement sous la baie informatique lors d'une palettisation de cette dernière grâce à l'enlèvement des dispositifs amovibles à roulettes.

Selon une autre particularité, les glissières sont constituées de deux jeux de rails de guidage horizontaux reliés à la face inférieure de la baie informatique, le premier jeu de rails étant disposé à une extrémité avant de la baie informatique et le second jeu de rails étant disposé à une extrémité arrière de la baie informatique, les glissières comprenant chacune au moins un logement délimité par les rails et la face inférieure de la baie informatique pour recevoir en translation un moyen correspondant de fixation.

Selon une autre particularité, chacune des glissières comprend un organe de butée pour marquer une fin de course du moyen de fixation reçu dans la glissière.

Un autre objet de l'invention est de proposer une palette de transport coopérant étroitement avec une baie informatique et permettant de minimiser les difficultés de transport.

A cet effet, l'invention concerne une palette de transport spécifiquement adaptée pour constituer avec une baie informatique l'agencement selon l'invention, caractérisée en ce qu'elle comporte :
- deux modules latéraux comportant chacun une face supérieure sur laquelle sont montés des moyens de fixation du type incluant au moins un organe de glissement en translation pour coopérer mécaniquement avec un moyen correspondant monté sous une baie informatique, de façon à rendre la baie informatique solidaire de la palette ; et
- au moins un moyen support intermédiaire du type séparable du reste de la palette et comprenant des éléments d'accrochage respectifs pour raccorder les modules latéraux.

Ainsi, la palette à modules séparables selon l'invention permet avantageusement une dépalettisation progressive de la baie informatique.

Selon une autre particularité, les deux modules latéraux comportent chacun une surface supérieure équipée d'au moins un plateau parallèle à ladite surface supérieure, plateau sous lequel sont formées des gorges ou rainures adjacentes à ladite surface supérieure.

Selon une autre particularité, le moyen support intermédiaire et les modules latéraux de la palette comportent chacun une face supérieure pour former dans un même plan horizontal le dessus de la palette, ledit moyen support intermédiaire comprenant au moins un tasseau formé sur sa face supérieure pour soutenir la face inférieure d'une baie informatique ledit moyen support intermédiaire étant de moindre épaisseur par rapport à l'épaisseur des modules latéraux, de façon à laisser un espacement entre le niveau le plus bas de la palette et la partie la plus basse du moyen support intermédiaire, cet espacement facilitant la séparation du moyen support intermédiaire par rapport au reste de la palette.

Un autre objet de l'invention concerne un procédé de conditionnement d'une baie informatique à l'aide d'une palette de transport qui permet de maximiser la hauteur utile de la baie informatique tout en facilitant le transport et la mise en place de la baie informatique.

A cet effet, l'invention propose un procédé de conditionnement d'une baie informatique pour son transport, la baie informatique étant du type associable à des roulettes s'étendant verticalement d'une première distance déterminée par rapport à au moins une face inférieure de la baie informatique, caractérisé en ce qu'il est mis en oeuvre par l'intermédiaire d'une palette de transport comportant au moins deux modules latéraux et un moyen support intermédiaire de type séparable permettant de raccorder les modules latéraux, le procédé comportant :
- une étape de fourniture de deux moyens d'ancrage distincts montés solidaires à la baie informatique, répartis sous la face inférieure de la baie informatique, de part et d'autre d'un plan médian vertical ;
- une étape de palettisation incluant une translation horizontale pour disposer ladite palette sous la baie informatique, parallèlement audit plan médian ; et
- une étape de fixation réalisée lors de la translation horizontale incluant d'une part la fixation d'un premier des modules latéraux de la palette à un premier des moyens d'ancrage, et d'autre part la fixation d'un second des modules latéraux de la palette à un second des moyens d'ancrage, de façon à ce que le dessus de la palette soit espacé de la face inférieure de la baie informatique d'une seconde distance déterminée strictement inférieure à la dite première distance déterminée.

Selon une autre particularité, l'étape de première fixation comprend l'insertion de plateaux dans des glissières respectives formant les moyens d'ancrage sous la baie informatique, les plateaux étant répartis sur chacun des modules latéraux.

Selon une autre particularité, le procédé comprend une étape d'enlèvement dudit moyen support intermédiaire incluant une désolidarisation des modules latéraux respectifs de ce moyen support intermédiaire et un déplacement en translation sensiblement horizontale du moyen support intermédiaire, de façon à laisser un vide entre les modules latéraux.

Selon une autre particularité, l'étape d'enlèvement du moyen support intermédiaire est suivie d'une étape de levage de l'ensemble formé par la baie et le reste de la palette fixé à la baie informatique et d'une étape d'enlèvement par translation horizontale des modules latéraux respectifs pour les remplacer par des dispositifs amovibles à roulettes se fixant aux moyens d'ancrage de la baie informatique selon un mouvement de translation horizontal.

L'invention, avec ses caractéristiques et avantages, ressortira plus clairement à la lecture de la description faite en référence aux dessins annexés dans lesquels:
- la figure 1 représente une vue en perspective illustrant le glissement d'une palette selon l'invention sous une baie informatique pourvue de moyens d'ancrage,
- la figure 2 représente une vue en coupe transversale par rapport au plan médian P1 de la figure 1 illustrant la coopération de la baie avec la palette selon l'invention,
- la figure 3A représente une vue de côté d'un dispositif amovible à roulettes associé à la baie informatique et la figure 3B montre une vue en perspective de ce même dispositif amovible à roulettes,
- la figure 4 montre une vue en perspective d'une baie de l'art antérieur palettisée avec ses rampes de dépalettisation,
- la figure 5 représente un agencement selon l'invention disposé à gauche de la figure et comparé à un agencement connu disposé à droite de la figure,
- la figure 6 montre une vue en perspective d'une baie selon l'invention liée physiquement à la palette à modules séparables de l'invention,
- la figure 7 représente un détail du dessous de la baie selon l'invention,
- la figure 8 illustre la succession d'étapes réalisées selon l'invention lors d'une phase de dépalettisation de la baie informatique.

Dans tout ce qui suit, on entendra par baie informatique toute structure de type haute densité avec un matériel permettant une utilisation dans des centres de données, des salles réseau ou des armoires de câblage.

Afin de « maximiser » la hauteur utile d'une baie dont la hauteur hors tout sur palette et emballée ne doit pas dépasser 2 m, l'agencement de conditionnement selon l'invention doit permettre une étroite coopération physique entre le dessus de la palette et la face inférieure de la baie informatique. En effet, la baie dont la masse peut atteindre 1,2 tonnes doit pouvoir être déplacée avec un appareil de levage (50) de type transpalette et passer sous une porte dont la hauteur standard est de 2 m.

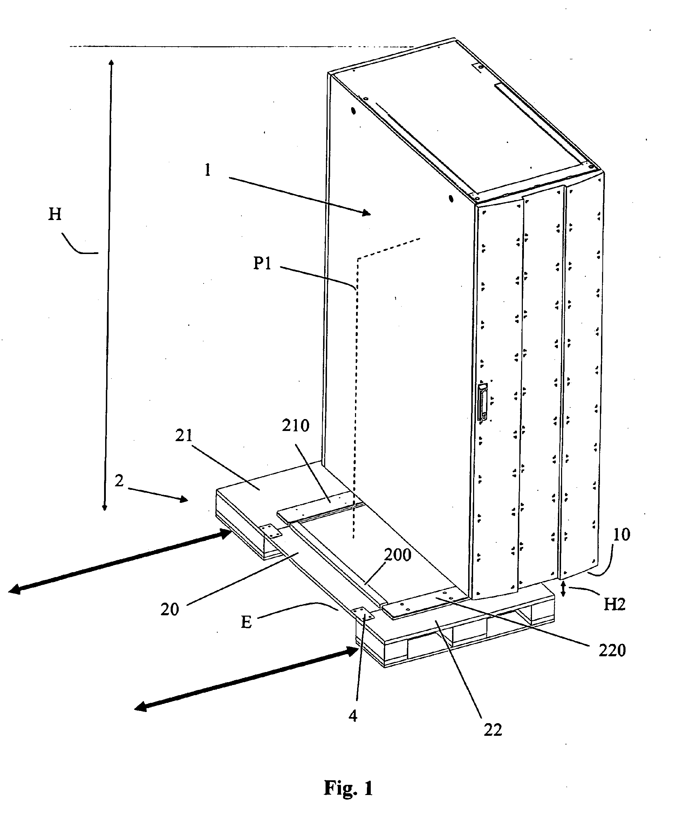

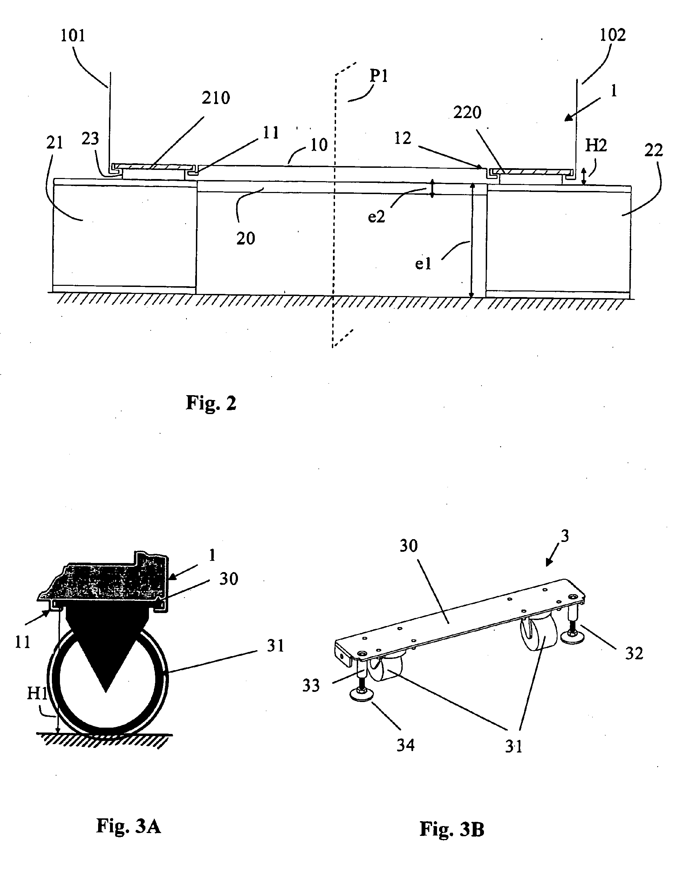

Dans le mode de réalisation présenté aux figures 1 et 2, la baie informatique est amenée sans ses roulettes sur une palette (2) de transport formée de plusieurs morceaux. Ceci est réalisé préalablement à la livraison de la baie, au cours d'une phase de conditionnement. La baie (1) peut être palettisée ainsi, sans que les roulettes (31) soient initialement fixées sou la baie informatique (1), à condition qu'il soit possible de fixer facilement par la suite les roulettes (31) associées à cette baie (1).

Il est donc important de rendre facile la phase consistant à désolidariser la baie de sa palette et fixer les roulettes. Pour cela, il convient d'utiliser un chariot élévateur (outil commun fortement utilisé, du type transpalette) pour soulever la baie (1) et enlever la palette (2). Nous remarquons qu'à ce moment précis, il est difficile de soulever à la fois la baie (1) en passant un chariot élévateur au travers de la palette (2) et d'enlever cette dernière. Pour résoudre cela, le procédé de conditionnement selon l'invention prévoit l'utilisation dune palette (2) originale en au moins trois morceaux séparables. Tous les morceaux sont liés entre eux par un système mécanique démontable puis désolidarisés pour rendre indépendant le soulèvement de la baie (1) et le retrait de la palette (2).

En référence à la figure 1, la palette comprend par exemple deux modules latéraux (21, 22) et au moins un moyen support intermédiaire (20) du type séparable du reste de la palette et permettant de raccorder les modules latéraux (21, 22). Les modules latéraux (21, 22) sont séparés l'un de l'autre par le moyen support intermédiaire (20) et répartis de part et d'autre d'un plan médian vertical (P1). Dans un mode de réalisation préféré de l'invention, le moyen support intermédiaire possède une surface correspondant à plus du tiers de la surface de la palette (2), les modules latéraux formant par exemple chacun moins d'un tiers de la surface de la palette (2).

La coopération étroite entre la baie informatique (1) et la palette (2) correspond à un agencement de conditionnement, permettant le transport de la baie (1) à l'aide du chariot élévateur ou tout appareil de levage (50) de ce type. Comme illustré à la figure 2, la baie informatique (1) peut être de forme classique, parallélépipédique, et associée à des roulettes (31) s'étendant verticalement d'une première distance déterminée (H1) par rapport à au moins une face inférieure (10) de cette baie (1). La baie informatique (1) est rendue solidaire de la palette de transport (2) par deux moyens d'ancrage (12) répartis sous la face inférieure (10) de la baie informatique, de part et d'autre du plan médian vertical (P1). Les modules latéraux (21, 22) de la palette (12) comportent chacun des moyens (210, 220, 23) agencés pour se fixer de façon amovible aux moyens d'ancrage (12) respectifs de la baie informatique (1). Ces moyens (210, 220, 23) de fixation et les moyens d'ancrage (12) sont disposés en vis-à-vis de façon à assurer une coopération étroite entre palette (2) et baie (1) et à maintenir en position horizontale la face inférieure (10) de la baie informatique (1).

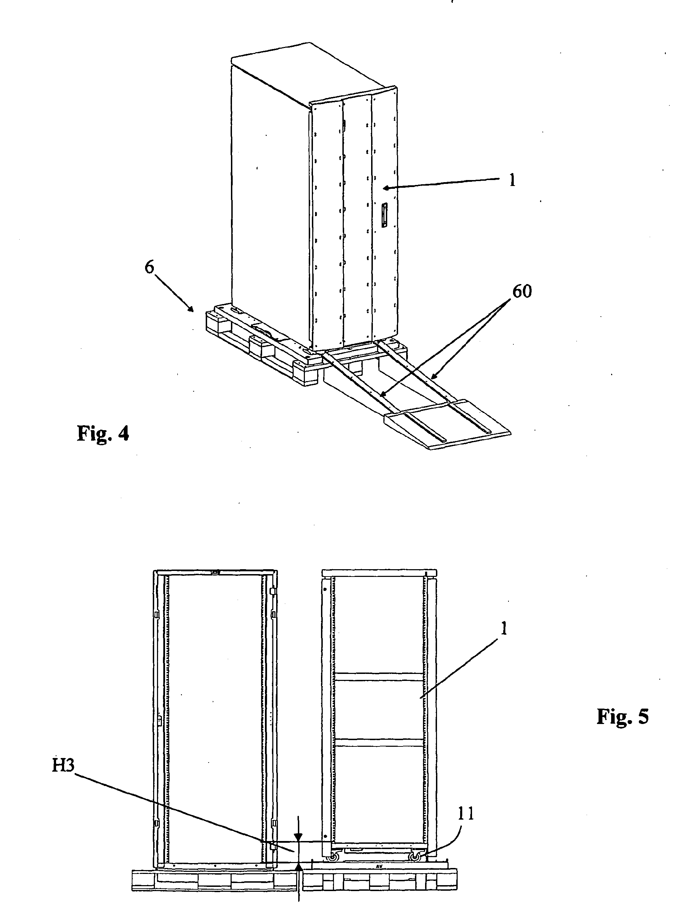

Comme illustré à la figure 2, le dessus de la palette (2) est alors espacé de la face inférieure (10) de la baie informatique (1) d'une seconde distance déterminée (H2) qui est strictement inférieure à la dite première distance déterminée (H1). Autrement dit, le fait de palettiser ainsi la baie informatique sans utiliser les roulettes (31) entre la palette de transport (2) et la baie (1), permet de gagner en hauteur utile, le supplément de hauteur lié aux roulettes étant supprimé. On comprend alors que l'invention apport un gain de hauteur (H3) qui peut être transféré à la baie proprement dite, comme illustré par la figure 5.

Contrairement aux procédés connus, correspondant à la figure 4, dans lesquels la baie informatique (1) doit être amenée via ses roulettes sur le plateau supérieur de la palette (6) par une rampe de chargement (60) solidaire ou rapportée à la palette (6), la solution selon l'invention propose plutôt de superposer la baie à la palette par déplacement de la palette, suivant la direction des flèches illustrées à la figure 1. L'étape de palettisation comporte en effet une translation horizontale pour disposer ladite palette sous la baie informatique. Cette translation peut s'effectuer en outre parallèlement au plan médian (P1). L'étape de palettisation s'accompagne d'une étape de fixation réalisée lors de la translation horizontale, un premier (21) des modules latéraux de la palette (2) se fixant à un premier des moyens d'ancrage (12) et un second (22) des modules latéraux de la palette se fixant à un second des moyens d'ancrage (12).

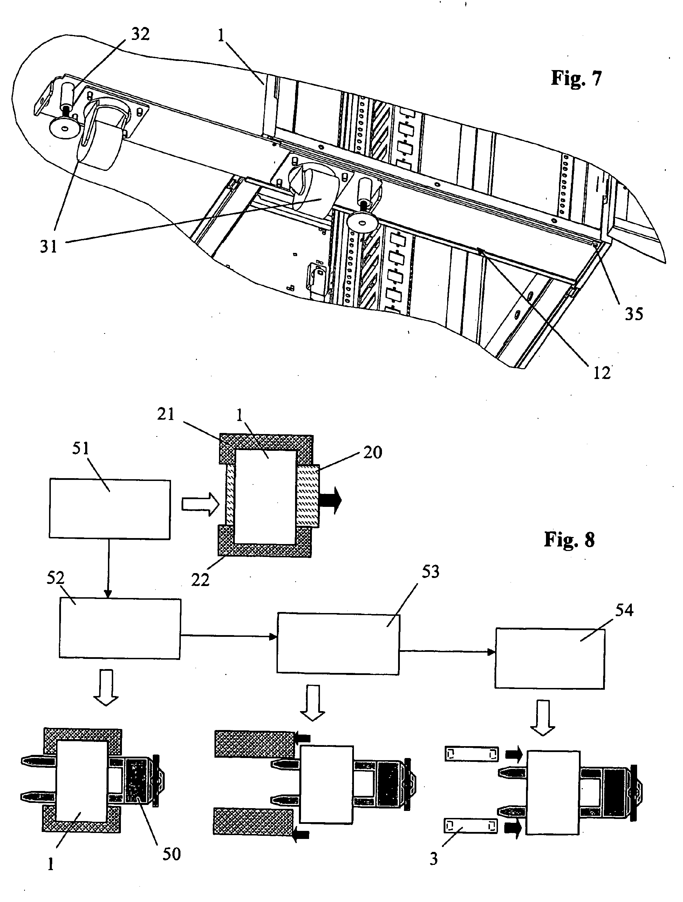

Dans le mode de réalisation des figures 2 et 7, les deux moyens d'ancrage (12) comprenant des glissières respectives parallèles adaptées à la fois pour recevoir de façon interchangeable des dispositifs amovibles (3) à roulettes (31) et les moyens (210, 220, 23) de fixation amovible de la palette de transport (2). Ces glissières, disposées de façon sensiblement horizontale, permettent de minimiser l'espacement sous la baie informatique (1) puisque les dispositifs amovibles (3) à roulettes (31) peuvent être séparés de la baie (1). Les roulettes peuvent en variante être rapportées à la baie (1) par un mode de fixation équivalent, par exemple à l'aide de vis, rivet, clips ou autre moyen de fixation amovible. Dans d'autres modes de réalisation de l'invention, les roulettes (31) peuvent être de type escamotable ou pouvant être ramenées dans un logement de la baie (1), respectivement dans un logement de la palette (2). Ces modes de réalisation permettent chacun de réduire l'espacement entre baie et palette à une distance (H2) nettement inférieure au diamètre des roulettes (31) habituellement utilisées pour supporter la baie (pouvant atteindre 1,2 tonnes). Alors que ces roulettes possèdent un diamètre supérieur à 8 cm et que la distance (H1, figure 3A) correspondant à l'encombrement en hauteur de ses roulettes est de l'ordre de 17 cm, la distance (H2) entre baie et palette est par exemple comprise entre 0,4 et 4 cm selon la présente invention.

Comme montré sur les figures 3A, 3B et 7, chaque dispositif amovible (3) à roulettes (31) est doté d'un organe de coopération (30) prévu pour se fixer à un des moyens d'ancrage (12) de la baie informatique (1). En référence à la figure 2, la baie possède sur sa structure basse ou face inférieure (10) deux jeux de rails de guidages (11) identiques. Ces rails (11) horizontaux, forment les glissières permettant de recevoir par translation tout élément qui dispose d'un système prévu à cet effet : plateau avec roulettes (31) et vérins (32) ou palette avec plateau (par exemple en acier). Dans un mode de réalisation de l'invention, les glissières sont constituées de deux jeux de rails de guidage (11) horizontaux reliés à la face inférieure (10) de la baie informatique (1), le premier jeu de rails étant disposé à une extrémité avant (101) de la baie informatique (1) et le second jeu de rails étant disposé à une extrémité arrière (102) de cette baie (1). Les glissières comprennent chacune au moins un logement délimité par les rails (11) et la face inférieure (10) de la baie informatique (1) pour recevoir en translation le moyen correspondant de fixation prévu sur le dispositif amovible (3) à roulettes ou sur le module latéral (21, 22) de la palette (2).

Le ou les plateaux formant l'organe de coopération (30) peuvent être tout d'abord glissés dans les rails (11) de guidage jusqu'à ce qu'ils soient en position. Dans le mode de réalisation de la figure 7, la position peut être définie par la présence d'une butée mécanique de fin de course. L'organe de butée (35) peut être prévu sur la structure basse de la baie informatique (1), associé à chacune des glissières pour marquer une fin de course du moyen de fixation reçu dans la glissière.

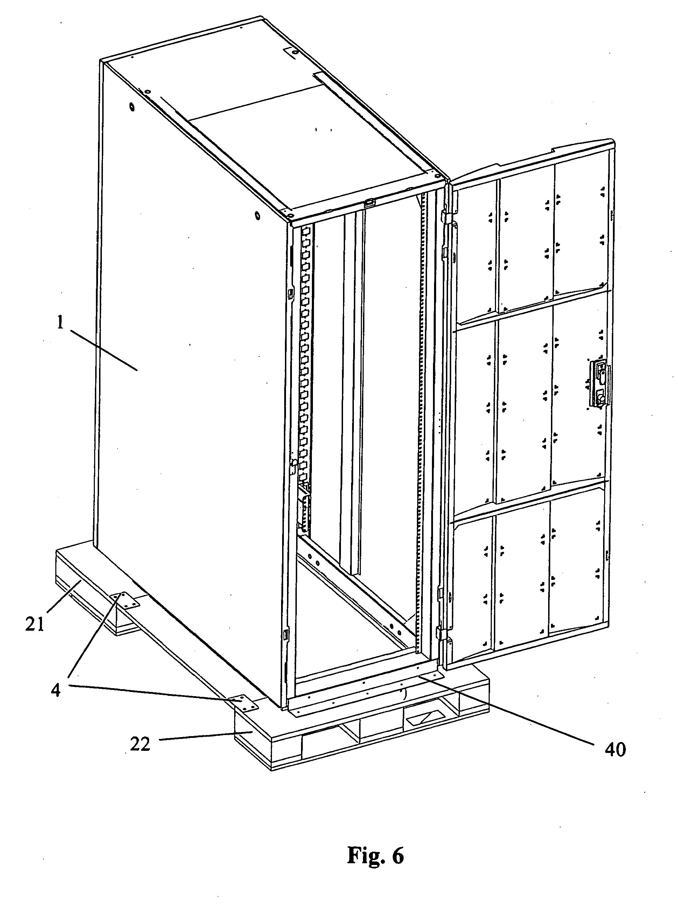

En référence à la figure 6, la palette (2) peut ensuite être liée de façon complémentaire à la baie (1), par exemple à l'aide d'un système démontable de liaison mécanique. Après le positionnement jusqu'à l'organe de butée (35) des moyens de fixation des modules latéraux (21, 22), cette liaison mécanique permet de supprimer le dernier degré de liberté entre la baie (1) et la palette (2). Plus généralement, la palette (2) peut comporter des moyens (40) de blocage en position de la baie (1) répartis sur chacun des modules latéraux (21, 22). La liaison mécanique baie / palette est par exemple assurée par un système de cornière vissée, ce système pouvant être prévu à l'arrière comme à l'avant de la baie informatique (1).

Dans le mode de réalisation des figures 1 et 2, la palette (2) comporte un dessus sensiblement horizontal et les modules latéraux (21, 22) peuvent s'apparenter chacun à une portion de palette standard (plancher supérieur, plot, semelle...) à un détail près : chacun des modules latéraux (21, 22) possède au moins un plateau (210, 220) en acier fixé sur le plancher supérieur. C'est ce plateau en acier qui effectue la translation dans les rails (11) de la baie (1) constituant ainsi une liaison glissière entre cette dernière et la palette (2). Le fait d'associer le plateau (210, 220) à la palette (2) assure une certaine rapidité et sécurité lors de la dépalettisation. En outre, les dispositifs amovibles (3) à roulettes peuvent être dotés d'un organe de coopération (30) avec le même type de plateau que les modules latéraux. Ainsi, avec un plateau constitué par exemple d'une plaque en acier, l'installation des dispositifs (3) à roulettes est très rapide, chaque dispositif (3) étant ramené à la baie par glissement du plateau dans les rails de guidage (11). Naturellement, tout autre organe de glissement en translation peut être prévu sur les modules latéraux (21, 22) pour coopérer mécaniquement avec un moyen correspondant monté sous la baie informatique (1), de façon à rendre la baie informatique solidaire de la palette (2).

Comme illustré à la figure 2, les deux modules latéraux (21, 22) comprennent chacun une surface supérieure équipée d'au moins un plateau (210, 220) surélevé et parallèle à ladite surface supérieure, plateau sous lequel sont formées des gorges ou rainures (23) adjacentes à ladite surface supérieure pour recevoir l'extrémité d'un rail (11) des glissières.

Sur le dessus de la palette formé par les faces supérieures respectives des morceaux de la palette (2), on retrouve en plus des plateaux (210, 220) au moins un tasseau (200) formé sur la face supérieure du moyen support intermédiaire (20). La présence de tasseaux (200) assure un soutien de la face inférieure (10) de la baie informatique (1). Le plancher de raccordement formé par le moyen support intermédiaire (20) peut consister en une planche et deux tasseaux (200). Ce plancher de raccordement ou support intermédiaire analogue est ensuite lié mécaniquement par un système démontable aux deux modules latéraux (21, 22). Comme représenté à la figure 1, il faut bien comprendre que la structure de la baie (1) est posée directement sur les embases métalliques (plateaux) et les tasseaux (200) de la palette (2). Comme montré à la figure 2, les plateaux (210, 220) des modules latéraux (21, 22) sont en contact direct avec la face inférieure (10) de la baie informatique (1). Il n'y a plus les roulettes (31) entre le dessus de la palette (2) et le dessous de la baie (1), ce qui permet de gagner en hauteur utile. La disposition proposée selon l'invention permet donc de transporter une baie ayant une hauteur (H) de l'ordre de 1,80 m (40U) sur sa palette (2) jusque dans la salle ou elle sera déballée et mise en fonctionnement.

Le procédé de conditionnement selon l'invention va être à présent décrit en référence aux figures 1, 2 et 8.

Le procédé comprend au préalable une étape de palettisation pour disposer l'intégralité de la palette (2) sous la baie informatique (1), au cours de laquelle on réalise une étape de fixation entre les modules latéraux de la palette (2) et les moyens d'ancrage (12) de la baie informatique (1). Une fixation complémentaire peut être réalisée, comme montré à la figure 6, pour stabiliser la baie (1) sur la palette (2). Un obstacle qui apparaît après la palettisation est qu'il devient difficile de soutenir la baie palettisée avec un moyen de levage habituel et remplacer la palette (2) par les roulettes (31).

Afin de surmonter cet obstacle, le procédé prévoit d'utiliser la palette constituée de morceaux séparables. Le moyen support intermédiaire (20) peut être de moindre épaisseur (e1) par rapport à l'épaisseur (e2) des modules latéraux (21, 22), comme illustré à la figure 2, de façon à laisser un espacement (E) entre le niveau le plus bas de la palette (2) et la partie la plus basse du moyen support intermédiaire (20). Cet espacement (E) permet de faciliter la séparation du moyen support intermédiaire (20) par rapport au reste de la palette (2). En référence à la figure 8, le procédé comporte ainsi une étape (51) d'enlèvement du moyen support intermédiaire (20), au cours de laquelle les modules latéraux (210, 22) respectifs sont désolidarisés de ce moyen support intermédiaire (20). Un déplacement en translation sensiblement horizontale du moyen support intermédiaire (20) est ensuite effectué, de façon à laisser un vide entre les modules latéraux (21, 22). Ceci permet alors d'introduire un transpalette entre les deux modules latéraux (21, 22) pour rendre indépendant le soulèvement de la baie (1) et le retrait du reste de la palette. Ce type de procédure qui utilise un chariot élévateur (transpalette) ou moyen de levage analogue permet de limiter le nombre d'opérateurs à une seule personne.

Comme représenté à la figure 8, l'étape (51) d'enlèvement du moyen support intermédiaire (20) est donc suivie d'une étape (52) de levage de l'ensemble formé par la baie informatique (1) et le reste (21, 22) de la palette encore fixé à cette baie (1). Lors de cette étape (52), le chariot élévateur est par exemple glissé par le coté entre l'avant de la baie et l'arrière de la baie, les modules latéraux (21, 22) étant disposés transversalement par rapport à la longueur de la baie informatique (1). Ainsi, le centre de gravité de la baie (1) se trouve au-dessus du chariot élévateur : la baie est en équilibre stable. Il s'ensuit une étape (53) d'enlèvement par translation horizontale des modules latéraux (21 22) respectifs pour les remplacer, lors d'une étape suivante (54), par les dispositifs amovibles (3) à roulettes (31). L'insertion de ces dispositifs (3) peut s'effectuer selon un mouvement de translation horizontal. Les roulettes (31) sont ainsi rapportées à la place des deux modules latéraux (21, 22) de la palette (2). La dépalettisation s'achève ainsi, la baie munie de ses roulettes (31) étant reposée sur le sol à l'aide du chariot élévateur.

En référence à la figure 3B, les dispositifs amovibles (3) à roulettes peuvent être dotés chacun d'au moins deux roulettes (31) et d'au moins deux vérins (32) de positionnement au sol ajustables verticalement. Les vérins comportent un socle (34) de contact au sol et un moyen (33) de réglage en hauteur du socle, le réglage en hauteur s'effectuant par exemple par vissage/dévissage.

Un des avantages de l'invention est de fournir un agencement de conditionnement permettant d'augmenter la hauteur utile d'une baie informatique tout en facilitant les opérations de transport sous les portes de hauteur standard (2m), l'agencement étant en outre conçu de façon originale pour faciliter la dépalettisation avec mise au sol de la baie munie de ses roulettes.

Il doit être évident pour les personnes versées dans l'art que la présente invention permet des modes de réalisation sous de nombreuses autres formes spécifiques sans l'éloigner du domaine d'application de l'invention comme revendiqué, l'invention ne devant pas être limitée aux détails donnés ci-dessus.

## Revendications

1. Agencement de conditionnement d'une baie informatique, du type transportable à l'aide d'un appareil de levage (50), comprenant une palette de transport (2) et une baie informatique (1), la baie informatique (1) étant du type associable à des roulettes (31) s'étendant verticalement d'une première distance déterminée (H1) par rapport à au moins une face inférieure (10) de la baie informatique (1), **caractérisé en ce que** la baie informatique (1) est rendue solidaire de la palette de transport (2) par deux moyens d'ancrage (12) de la baie informatique (1), répartis sous la face inférieure (10) de la baie informatique, de part et d'autre d'un plan médian vertical (P1), ladite palette (2) comportant deux modules latéraux (21, 22) et au moins un moyen support intermédiaire (20) du type séparable du reste de la palette et permettant de raccorder les modules latéraux (21, 22), un premier (21) des modules latéraux de la palette incluant des moyens (210, 23) de fixation amovible au premier moyen d'ancrage et un second (22) des modules latéraux de la palette incluant des moyens (220, 23) de fixation amovible au second moyen d'ancrage, les moyens (210, 220, 23) de fixation des modules latéraux (21, 22) et lesdits moyens d'ancrage (12) étant agencés en vis-à-vis pour maintenir en position horizontale la face inférieure (10) de la baie informatique (1), de sorte que le dessus de la palette (2) soit espacé de la face inférieure (10) de la baie informatique d'une seconde distance déterminée (H2) strictement inférieure à la dite première distance déterminée (H1).

2. Agencement selon la revendication 1, comportant au moins deux dispositifs amovibles (3) à roulettes (31) dotés chacun d'un organe de coopération (30) prévu pour se fixer à un des moyens d'ancrage (12) de la baie informatique (1).

3. Agencement selon la revendication 1 ou 2, dans lequel les moyens d'ancrage (12) sous la baie informatique (1) comprennent des glissières respectives, les glissières incluant des rails horizontaux (11), les deux modules latéraux (21, 22) comprenant chacun une surface supérieure équipée d'au moins un plateau (210, 220) parallèle à ladite surface supérieure, plateau sous lequel sont formées des gorges ou rainures (23) adjacentes à ladite surface supérieure pour recevoir l'extrémité d'un rail (11) des glissières.

4. Agencement selon la revendication 3, dans lequel les plateaux (210, 220) des modules latéraux (21, 22) sont en contact direct avec la face inférieure (10) de la baie informatique (1).

5. Agencement selon une des revendications 1 à 4, dans lequel les moyens d'ancrage (12) comprennent des glissières parallèles adaptées pour recevoir de manière interchangeable soit les modules latéraux (21, 22) de la palette de transport (2), soit des dispositifs amovibles (3) à roulettes (31).

6. Agencement selon une des revendications 2 à 5, dans lequel les dispositifs amovibles (3) à roulettes sont dotés chacun d'au moins deux roulettes (31) et d'au moins deux vérins (32) de positionnement au sol ajustables verticalement.

7. Agencement selon une des revendications 1 à 6, dans lequel le moyen support intermédiaire (20) et les modules latéraux (21, 22) de la palette (2) comportent chacun une face supérieure pour former dans un même plan horizontal le dessus de la palette (2), ledit moyen support intermédiaire (20) comprenant en outre au moins un tasseau (200) formé sur sa face supérieure pour soutenir ladite face inférieure (10) de la baie informatique (1).

8. Agencement selon une des revendications 1 à 7, dans lequel la seconde distance déterminée (H2) est comprise entre 0,4 et 4 cm.

9. Agencement selon une des revendications 1 à 8, dans lequel la palette (2) comporte des moyens (40) de blocage en position de la baie (1) répartis sur chacun des modules latéraux (21, 22).

10. Agencement selon une des revendications 1 à 9, dans lequel ledit moyen support intermédiaire (20) est de moindre épaisseur (e1) par rapport à l'épaisseur (e2) des modules latéraux (21, 22), de façon à laisser un espacement (E) entre le niveau le plus bas de la palette (2) et la partie la plus basse du moyen support intermédiaire (20), cet espacement (E) facilitant la séparation du moyen support intermédiaire (20) par rapport au reste de la palette.

11. Baie informatique (1) du type associable à des roulettes (31) disposées sous au moins une face inférieure (10) de la baie informatique et spécifiquement adaptée pour constituer avec une palette de transport (2) l'agencement selon une des revendications 1 à 10, **caractérisée en ce qu**'elle comporte :
- au moins deux dispositifs amovibles (3) à roulettes (31) ; et
- deux moyens d'ancrage (12) répartis sous la face inférieure (10) de la baie informatique (1), de part et d'autre d'un plan médian vertical (P1), les moyens d'ancrage (12) comprenant des glissières respectives parallèles adaptées à la fois pour recevoir de façon interchangeable les dispositifs amovibles (3) à roulettes (31) et des moyens (210, 220, 23) de fixation amovible d'une palette de transport (2), de façon à minimiser l'espacement sous la baie informatique (1) lors d'une palettisation de cette dernière grâce à l'enlèvement des dispositifs amovibles (3) à roulettes (31).

12. Baie informatique selon la revendication 11, dans laquelle les glissières sont constituées de deux jeux de rails de guidage (11) horizontaux reliés à la face inférieure (10) de la baie informatique (1), le premier jeu de rails étant disposé à une extrémité avant (101) de la baie informatique et le second jeu de rails étant disposé à une extrémité arrière (102) de la baie informatique (1), les glissières comprenant chacune au moins un logement délimité par les rails (11) et la face inférieure (10) de la baie informatique (1) pour recevoir en translation un moyen correspondant de fixation.

13. Baie informatique selon la revendication 12, dans laquelle chacune des glissières comprend un organe de butée (35) pour marquer une fin de course du moyen de fixation reçu dans la glissière.

14. Palette de transport (2) spécifiquement adaptée pour constituer avec une baie informatique (1) l'agencement selon une des revendications 1 à 10, **caractérisée en ce qu'**elle comporte :
- deux modules latéraux (21, 22) comportant chacun une face supérieure sur laquelle sont montés des moyens (210, 220, 23) de fixation du type incluant au moins un organe de glissement (210, 220) en translation pour coopérer mécaniquement avec un moyen correspondant monté sous une baie informatique (1), de façon à rendre la baie informatique solidaire de la palette (2) ; et
- au moins un moyen support intermédiaire (20) du type séparable du reste de la palette et comprenant des éléments d'accrochage (4) respectifs pour raccorder les modules latéraux (21, 22).

15. Palette de transport selon la revendication 14, dans laquelle les deux modules latéraux (21, 22) comportent chacun une surface supérieure équipée d'au moins un plateau parallèle (210, 220) à ladite surface supérieure, plateau sous lequel sont formées des gorges ou rainures (23) adjacentes à ladite surface supérieure.

16. Palette de transport selon la revendication 14 ou 15, dans laquelle le moyen support intermédiaire (20) et les modules latéraux (21, 22) de la palette comportent chacun une face supérieure pour former dans un même plan horizontal le dessus de la palette, ledit moyen support intermédiaire (20) comprenant au moins un tasseau (200) formé sur sa face supérieure pour soutenir la face inférieure (10) d'une baie informatique (1) ledit moyen support intermédiaire (20) étant de moindre épaisseur (e1) par rapport à l'épaisseur (e2) des modules latéraux (21, 22), de façon à laisser un espacement (E) entre le niveau le plus bas de la palette (2) et la partie la plus basse du moyen support intermédiaire (20), cet espacement (E) facilitant la séparation du moyen support intermédiaire (20) par rapport au reste de la palette (2).

17. Procédé de conditionnement d'une baie informatique (1) pour son transport, la baie informatique étant du type associable à des roulettes s'étendant verticalement d'une première distance déterminée (H1) par rapport à au moins une face inférieure (10) de la baie informatique (1), **caractérisé en ce qu'**il est mis en oeuvre par l'intermédiaire d'une palette de transport (2) comportant au moins deux modules latéraux (21, 22) et un moyen support intermédiaire (20) de type séparable permettant de raccorder les modules latéraux (21, 22), le procédé comportant :
- une étape de fourniture de deux moyens d'ancrage (12) distincts montés solidaires à la baie informatique (1), répartis sous la face inférieure (10) de la baie informatique, de part et d'autre d'un plan médian (P1) vertical ;
- une étape de palettisation incluant une translation horizontale pour disposer ladite palette sous la baie informatique, parallèlement audit plan médian (P1) ; et
- une étape de fixation réalisée lors de la translation horizontale incluant d'une part la fixation d'un premier (21) des modules latéraux de la palette (2) à un premier des moyens d'ancrage, et d'autre part la fixation d'un second (22) des modules latéraux de la palette à un second des moyens d'ancrage (12), de façon à ce que le dessus de la palette (2) soit espacé de la face inférieure (10) de la baie informatique (1) d'une seconde distance déterminée (H2) strictement inférieure à ladite première distance déterminée (H1).

18. Procédé de conditionnement selon la revendication 17, dans lequel l'étape de première fixation comprend l'insertion de plateaux (210, 220) dans des glissières respectives formant les moyens d'ancrage (12) sous la baie informatique (1), les plateaux (210, 220) étant répartis sur chacun des modules latéraux (21, 22).

19. Procédé de conditionnement selon la revendication 17 ou 18, comprenant une étape (51) d'enlèvement dudit moyen support intermédiaire (20) incluant une désolidarisation des modules latéraux (210, 22) respectifs de ce moyen support intermédiaire (20) et un déplacement en translation sensiblement horizontale du moyen support intermédiaire (20), de façon à laisser un vide entre les modules latéraux (21, 22).

20. Procédé de conditionnement selon la revendication 19, dans lequel l'étape (51) d'enlèvement du moyen support intermédiaire (20) est suivie d'une étape (52) de levage de l'ensemble formé par la baie (1) et le reste (21, 22) de la palette fixé à la baie informatique (1) et d'une étape (53) d'enlèvement par translation horizontale des modules latéraux (21 22) respectifs pour les remplacer lors d'une étape suivante (54) par des dispositifs amovibles (3) à roulettes (31) se fixant aux moyens d'ancrage (12) de la baie informatique selon un mouvement de translation horizontal.

## Claims

1. System for packaging a computer rack, of the type that is transportable with the aid of a lifting appliance (50), comprising a transport pallet (2) and a computer rack (1), the computer rack (1) being of the type that can be associated with castors (31) extending vertically a first given distance (H1) with respect to at least one lower face (10) of the computer rack (1), **characterised in that** the computer rack (1) is made integral with the transport pallet (2) by two means (12) for anchoring the computer rack (1), distributed under the lower face (10) of the computer rack, on either side of a vertical median plane (P1), said pallet (2) comprising two side modules (21, 22) and at least one intermediate support means (20) of the type that is separable from the rest of the pallet and making it possible to connect the side modules (21, 22), a first one (21) of the side modules of the pallet including removable means (210, 23) for fixing to the first anchorage means and a second one (22) of the side modules of the pallet including removable means (220, 23) for fixing to the second anchorage means, the means (210, 220, 23) for fixing the side modules (21, 22) and said anchorage means (12) being arranged facing each other in order to hold the lower face (10) of the computer rack (1) in a horizontal position, so that the top of the pallet (2) is spaced apart from the lower face (10) of the computer rack by a second given distance (H2) strictly less than said first given distance (H1).

2. System according to Claim 1, comprising at least two removable devices (3) with castors (31), each provided with a co-operation member (30) intended to be fixed to one of the means (12) for anchoring the computer rack (1).

3. System according to Claim 1 or 2, in which the anchorage means (12) under the computer rack (1) comprise respective sliders, the sliders including horizontal rails (11), the two side modules (21, 22) each comprising an upper surface equipped with at least one plate (210, 220) parallel to said upper surface, under which plate throats or grooves (23) are formed, adjacent to said upper surface, for accommodating the end of a rail (11) of the sliders.

4. System according to Claim 3, in which the plates (210, 220) of the side modules (21, 22) are in direct contact with the lower face (10) of the computer rack (1).

5. System according to one of Claims 1 to 4, in which the anchorage means (12) comprise parallel sliders adapted to receive interchangeably either the side modules (21, 22) of the transport pallet (2), or removable devices (3) with castors (31).

6. System according to one of Claims 2 to 5, in which the removable devices (3) with castors are each provided with at least two castors (31) and at least two vertically adjustable jacks (32) for positioning on the ground.

7. System according to one of Claims 1 to 6, in which the intermediate support means (20) and the side modules (21, 22) of the pallet (2) each comprise an upper face to form the top of the pallet (2) in the same horizontal plane, said intermediate support means (20) further comprising at least one cleat (200) formed on its upper face in order to support said lower face (10) of the computer rack (1).

8. System according to one of Claims 1 to 7, in which the second given distance (H2) is between 0.4 and 4 cm.

9. System according to one of Claims 1 to 8, in which the pallet (2) comprises means (40) for locking the rack (1) in position, distributed on each of the side modules (21, 22).

10. System according to one of Claims 1 to 9, in which said intermediate support means (20) is of a smaller thickness (e1) with respect to the thickness (e2) of the side modules (21, 22), so as to leave a spacing (E) between the lowest level of the pallet (2) and the lowest part of the intermediate support means (20), this spacing (E) facilitating the separation of the intermediate support means (20) from the rest of the pallet.

11. Computer rack (1) of the type that can be associated with castors (31) positioned under at least one lower face (10) of the computer rack and specifically adapted so as to constitute, together with a transport pallet (2) the system according to one of Claims 1 to 10, **characterised in that** it comprises:
- at least two removable devices (3) with castors (31); and
- two anchorage means (12) distributed under the lower face (10) of the computer rack (1), on either side of a vertical median plane (P1), the anchorage means (12) comprising respective parallel sliders adapted both for accommodating interchangeably the removable devices (3) with castors (31) and removable means (210, 220, 23) for fixing a transport pallet (2), so as to minimise the spacing under the computer rack (1) when the latter is palletised by removing the removable devices (3) with castors (31).

12. Computer rack according to Claim 11, in which the sliders are constituted by two sets of horizontal guide rails (11) connected to the lower face (10) of the computer rack (1), the first set of rails being positioned at a front end (101) of the computer rack and the second set of rails being positioned at a rear end (102) of the computer rack (1), the sliders each comprising at least one housing delimited by the rails (11) and the lower face (10) of the computer rack (1) in order to receive in translation a corresponding fixing means.

13. Computer rack according to Claim 12, in which each of the sliders comprises a stop member (35) in order to mark an end of travel for the fixing means received in the slider.

14. Transport pallet (2) specifically adapted so as to constitute, together with a computer rack (1), the system according to one of Claims 1 to 10, **characterised in that** it comprises:
- two side modules (21, 22) each comprising an upper face on which fixing means (210, 220, 23) are mounted, of the type including at least one member (210, 220) sliding in translation in order to co-operate mechanically with a corresponding means mounted under a computer rack (1), so as to make the computer rack integral with the pallet (2); and
- at least one intermediate support means (20) of the type that is separable from the rest of the pallet and comprising respective fixing elements (4) in order to connect the side modules (21, 22).

15. Transport pallet according to Claim 14, in which the two side modules (21, 22) each comprise an upper surface equipped with at least one plate (210, 220) parallel to said upper surface, under which plate throats or grooves (23) are formed, adjacent to said upper surface.

16. Transport pallet according to Claim 14 or 15, in which the intermediate support means (20) and the side modules (21, 22) of the pallet each comprise an upper face so as to form, in the same horizontal plane, the top of the pallet, said intermediate support means (20) comprising at least one cleat (200) formed on its upper face in order to support the lower face (10) of a computer rack (1), said intermediate support means (20) being of a smaller thickness (e1) with respect to the thickness (e2) of the side modules (21, 22), so as to leave a spacing (E) between the lowest level of the pallet (2) and the lowest part of the intermediate support means (20), this spacing (E) facilitating the separation of the intermediate support means (20) from the rest of the pallet (2).

17. Method of packaging a computer rack (1) for transport, the computer rack being of the type that can be associated with castors extending vertically a first given distance (H1) with respect to at least one lower face (10) of the computer rack (1), **characterised in that** it is implemented via a transport pallet (2) comprising at least two side modules (21, 22) and an intermediate support means (20) of the separable type making it possible to connect the side modules (21, 22), the method comprising:
- a step of supplying two distinct anchorage means (12) mounted integral with the computer rack (1), distributed under the lower face (10) of the computer rack, on either side of a vertical median plane (P1);
- a palletisation step including horizontal translation in order to position said pallet under the computer rack, parallel to said median plane (P1); and
- a fixing step performed during the horizontal translation including, on the one hand, the fixing of a first one (21) of the side modules of the pallet (2) to a first one of the anchorage means and, on the other hand, the fixing of a second one (22) of the side modules of the pallet to a second one of the anchorage means (12), so that the top of the pallet (2) is spaced apart from the lower face (10) of the computer rack (1) by a second given distance (H2) strictly less than said first given distance (H1).

18. Packaging method according to Claim 17, in which the first fixing step comprises the insertion of plates (210, 220) into the respective sliders forming the anchorage means (12) under the computer rack (1), the plates (210, 220) being distributed on each of the side modules (21, 22).

19. Packaging method according to Claim 17 or 18, comprising a step (51) of removing said intermediate support means (20) including dissociation of the respective side modules (210, 22) of this intermediate support means (20) and a substantially horizontal displacement in translation of the intermediate support means (20), so as to leave an empty space between the side modules (21, 22).

20. Packaging method according to Claim 19, in which the step (51) of removing the intermediate support means (20) is followed of a step (52) of lifting the assembly formed by the rack (1) and the rest (21, 22) of the pallet fixed to the computer rack (1) and by a step (53) of removing the respective side modules (21 22) by horizontal translation in order to replace them in a subsequent step (54) by removable devices (3) with castors (31) fixed to the means (12) for anchoring the computer rack according to a horizontal translation movement.

## Patentansprüche

1. Konditionierungs-Anordnung für einen Informatik-Schrank, von der Art, der mit Hilfe eines Hebe-Gerätes (50) transportierbar ist, eine Transport-Palette (2) und einen Informatik-Schrank (1) enthaltend, wobei der Informatik-Schrank (1) von der Art ist, die mit Rollen (31) verbunden werden kann, die sich vertikal über eine bestimmte Distanz (H1) bezüglich mindestens einer unteren Fläche (10) des Informatik-Schranks erstrecken, **dadurch gekennzeichnet, dass** der Informatik-Schrank (1) mit der Transport-Palette (2) durch zwei Verankerungs-Mittel (12) des Informatik-Schranks zusammenhaltend gemacht ist, die unter der unteren Fläche (10) des Informatik-Schranks (1) verteilt sind, beiderseits einer vertikalen Mittel-Ebene (P1), wobei die genannte Palette (2) zwei seitliche Module (21, 22) und mindestens ein Zwischen-Stützmittel (20) enthält, von der Art, dass es vom Rest der Palette trennbar ist und es ermöglicht, die seitlichen Module (21, 22) zu verbinden, wobei ein erstes der seitlichen Module (21) der Palette Mittel (210, 23) zur trennbaren Fixierung am ersten Verankerungs-Mittel und ein zweites der seitlichen Module (22) der Palette Mittel (220, 23) zur trennbaren Fixierung am zweiten Verankerungs-Mittel enthält, wobei die Fixierungs-Mittel (210, 220, 23) der seitlichen Module (21, 22) und die genannten Verankerungs-Mittel (12) einander gegenüberliegend angeordnet sind, um die untere Fläche (10) des Informatik-Schranks in horizontaler Position zu halten, dergestalt, dass die Oberseite der Palette (2) von der unteren Fläche (10) des Informatik-Schranks um eine bestimmte, zweite Distanz (H2) beabstandet ist, die streng geringer ist als die genannte, bestimmte erste Distanz (H1).

2. Anordnung nach Anspruch 1, die mindestens zwei abnehmbare Vorrichtungen (3) mit Rollen (31) enthält, die jeweils mit einem Verbindungselement (30) versehen sind, dass dazu vorgesehen ist, sich an einem der Verankerungs-Mittel (12) des Informatik-Schranks (1) zu fixieren.

3. Anordnung nach Anspruch 1 oder 2, in der die Verankerungs-Mittel (12) unter dem Informatik-Schrank (1) jeweils Gleitführungen enthalten, wobei die Gleitführungen horizontale Schienen (11) enthalten, wobei die seitlichen Module (21, 22) jeweils eine obere Oberfläche enthalten, die mit mindestens einem Boden (210, 220) ausgestattet ist, der parallel zur genannten oberen Oberfläche ist, wobei unter dem Boden Rillen oder Nute (23) geformt sind, die an die genannte, obere Oberfläche anliegen, um ein Ende einer Schiene (11) der Gleitführungen aufzunehmen.

4. Anordnung nach Anspruch 3, in der die Böden (210, 220) der seitlichen Module (21, 22) in direktem Kontakt mit der unteren Fläche (10) des Informatik-Schranks stehen.

5. Anordnung nach einem der Ansprüche 1 bis 4, in der die Verankerungs-Mittel (12) parallele Gleitführungen enthalten, die in austauschbarer Weise für die Aufnahme von entweder den seitlichen Modulen (21, 22) der Transport-Palette (2) oder den abnehmbaren Vorrichtungen (3) mit Rollen (31) geeignet sind.

6. Anordnung nach einem der Ansprüche 2 bis 5, in der die abnehmbaren Vorrichtungen (3) mit Rollen jeweils mit mindestens zwei Rollen (31) und mindestens zwei vertikal einstellbaren Stützen (32) zur Positionierung auf dem Boden ausgestattet sind.

7. Anordnung nach einem der Ansprüche 1 bis 6, in der das Zwischen-Stützmittel (20) und die seitlichen Module (21, 22) der Palette (2) jeweils eine obere Oberfläche besitzen, so, dass sie in einer selben, horizontalen Ebene die Oberseite der Palette (2) formen, wobei das Zwischen-Stützmittel (20) des Weiteren mindestens eine Leiste (200) enthält, die auf seiner oberen Fläche geformt ist, um die genannte, untere Fläche (10) des Informatik-Schranks (1) zu unterstützen.

8. Anordnung nach einem der Ansprüche 1 bis 7, in der die zweite, festgelegte Distanz (H2) zwischen 0,4 und 4 cm liegt.

9. Anordnung nach einem der Ansprüche 1 bis 8, in der die Palette (2) Mittel (40) zur Positionsblockierung des Schranks (1) enthält, die auf jedem der seitlichen Module (21, 22) angeordnet sind.

10. Anordnung nach einem der Ansprüche 1 bis 9, in der das genannte Zwischen-Stützmittel (20) in Bezug auf die Dicke (e2) der seitlichen Module (21, 22) von geringerer Dicke (e1) ist, derart, dass ein Raum (E) zwischen dem niedrigsten Niveau der Palette (2) und dem niedrigsten Teil des Zwischen-Stützmittels (20) bleibt, wobei dieser Raum (E) die Trennung des Zwischen-Stützmittels (20) in Bezug auf den Rest der Palette erleichtert.

11. Informatik-Schrank (1) derart, dass er mit Rollen (31) verbunden werden kann, die unter mindestens einer unteren Fläche (10) des Informatik-Schranks angeordnet sind, und speziell dafür angepasst, mit einer Transport-Palette (2) die Anordnung nach einem der Ansprüche 1 bis 10 zu bilden, **dadurch gekennzeichnet, dass** er enthält:
- mindestens zwei abnehmbare Vorrichtungen (3) mit Rollen (31); und
- zwei Verankerungs-Mittel (12), die unter der unteren Fläche (10) des Informatik-Schranks (1) beiderseits einer vertikalen Mittel-Ebene (P1) verteilt sind, wobei die Verankerungs-Mittel (12) jeweils parallele Gleitführungen enthalten, die dafür ausgelegt sind, jeweils in austauschbarer Weise die abnehmbaren Vorrichtungen (3) mit Rollen (31) und abnehmbare Fixierungs-Mittel (210, 220, 23) einer Transport-Palette (2) aufzunehmen, derart, dass der Raum unter dem Informatik-Schrank (1) bei der Palettisierung der letzteren durch Entfernung der abnehmbaren Vorrichtung (3) mit Rollen (31) minimiert wird.

12. Informatik-Schrank nach Anspruch 11, bei dem die Gleitführungen aus zwei Sätzen von horizontalen Führungs-Schienen (11) bestehen, die mit der unteren Fläche (10) des Informatik-Schranks (1) verbunden sind, wobei der erste Satz von Schienen an einem vorderen Ende (101) des Informatik-Schranks (1) angeordnet ist, und der zweite Satz von Schienen an einem hinteren Ende (102) des Informatik-Schranks (1) angeordnet ist, wobei die Gleitführungen jeweils mindestens eine Aufnahme enthalten, die von den Schienen (11) und der unteren Fläche (10) des Informatik-Schranks (1) begrenzt wird, um ein entsprechendes Fixierungs-Mittel mit einer Translationsbewegung aufzunehmen.

13. Informatik-Schrank nach Anspruch 12, in der jede der Gleitführungen ein Anschlags-Mittel (35) enthält, um das Ende des Hubes des Fixierungs-Mittels festzulegen, das in der Gleitführung aufgenommen wird.

14. Transport-Palette (2), insbesondere dafür angepasst, um mit einem Informatik-Schrank (1) die Anordnung nach einem der Ansprüche 1 bis 10 zu bilden, **dadurch gekennzeichnet, dass** sie enthält:
- zwei seitliche Module (21, 22), die jeweils eine obere Fläche enthalten, auf der Fixierungs-Mittel (210, 220, 23) montiert sind, von der Art, die mindestens ein Translations-Gleitführungs-Mittel (210, 220) enthält, um mechanisch mit einem entsprechenden Mittel zusammenzuwirken, das unter einem Informatik-Schrank (1) montiert ist, derart, dass der Informatik-Schrank mit der Palette (2) verbunden werden kann ; und
- mindestens ein Zwischen-Stützmittel (20), derart, dass es vom Rest der Palette trennbar ist, und jeweils Festhalte-Elemente (4) enthält, um die seitlichen Module (21, 22) anzubinden.

15. Transport-Palette nach Anspruch 14, in der die beiden seitlichen Module (21, 22) jeweils eine obere Oberfläche enthalten, die mit mindestens einem zur genannten, oberen Oberfläche parallelen Boden (210, 220) ausgestattet ist, wobei unter dem Boden Rillen oder Nute (23) geformt sind, die an die genannte, obere Oberfläche anliegen.

16. Transport-Palette nach Anspruch 14 oder 15, in der das Zwischen-Stützmittel (20) und die seitlichen Module (21, 22) der Palette jeweils eine obere Fläche enthalten, so, dass sie in einer selben, horizontalen Ebene die Oberseite der Palette formen, wobei das genannte Zwischen-Stützmittel (20) mindestens eine Leiste (200) enthält, die auf seiner oberen Fläche geformt ist, um die untere Fläche (10) eines Informatik-Schranks (1) abzustützen, wobei das genannte Zwischen-Stützmittel (20) in Bezug auf die Dicke (e2) der seitlichen Module (21, 22) von geringerer Dicke (e1) ist, so dass ein Raum (E) zwischen dem untersten Niveau der Palette (2) und dem untersten Teil des Zwischen-Stützmittels (20) belassen wird, wobei dieser Raum (E) die Trennung des Zwischen-Stützmittels (20) in Bezug auf den Rest der Palette (2) vereinfacht.

17. Verfahren zur Konditionierung eines Informatik-Schranks (1) für seinen Transport, wobei der Informatik-Schrank von der Art ist, dass er mit Rollen verbunden werden kann, die sich vertikal über eine erste, bestimmte Distanz (H1) bezüglich mindestens einer unteren Fläche (10) des Informatik-Schranks (1) erstrecken, **dadurch gekennzeichnet, dass** es ausgeführt wird mittels einer Transport-Palette (2), die mindestens zwei seitliche Module (21, 22) und ein Zwischen-Stützmittel (20) enthält, derart, dass es abtrennbar ist und es ermöglicht, die seitlichen Module (21, 22) anzubinden, wobei das Verfahren enthält:
- einen Schritt der Bereitstellung von zwei Verankerungs-Mitteln (12), die getrennt an dem Informatik-Schrank (1) zusammenhaltend montiert sind, und beiderseits einer vertikalen Mittel-Ebene (P1) unter der unteren Fläche (10) des Informatik-Schranks verteilt sind ;
- einen Schritt der Palettisierung einschließlich einer horizontalen Verschiebung, um die genannte Palette parallel zur genannten Mittel-Ebene (P1) unter dem Informatik-Schrank abzulegen ; und
- einen Schritt der Fixierung, der durch die horizontale Verschiebung realisiert wird und einerseits die Fixierung eines ersten der seitlichen Module (21) der Palette an einem ersten der Verankerungs-Mittel und andererseits die Fixierung eines zweiten der seitlichen Module (22) der Palette an einem zweiten der Verankerungs-Mittel (12) einschließt, in der Weise, dass die Oberseite der Palette (2) zur unteren Fläche (10) des Informatik-Schranks (1) mit einer zweiten, bestimmten Distanz (H2) beabstandet ist, die streng geringer ist, als die genannte, erste bestimmte Distanz (H1).

18. Verfahren zur Konditionierung nach Anspruch 17, in dem der Schritt der ersten Fixierung die Einführung eines Bodens (210, 220) in entsprechende Gleitführungen enthält, die die Verankerungs-Mittel (12) unter dem Informatik-Schränk (1) bilden, wobei die Böden (210, 220) auf je einem der seitlichen Module (21, 22) angeordnet sind.

19. Verfahren zur Konditionierung nach Anspruch 17 oder 18, das einen Schritt (51) der Wegnahme des genannten Zwischen-Stützmittels (20) enthält, was jeweils eine Verbindungstrennung der seitlichen Module (210, 22) von diesem Zwischen-Stützmittel (20) und eine im Wesentlichen horizontale Translationsverschiebung des Zwischen-Stützmittels (20) einschließt, so dass eine Leere zwischen den seitlichen Modulen (21, 22) belassen wird.

20. Verfahren zur Konditionierung nach Anspruch 19, in dem auf den Schritt (51) der Wegnahme des Zwischen-Stützmittels (20) ein Schritt (52) der Anhebung des Ganzen folgt, das sich zusammensetzt aus dem Schrank (1) und dem Rest (21, 22) der Palette, die an dem Informatik-Schrank fixiert ist, und auf den ein Schritt (53) der Wegnahme der seitlichen Module (21, 22) durch jeweils horizontale Verschiebung folgt, um sie während einem folgenden Schritt (54) durch abnehmbare Vorrichtungen (3) mit Rollen (31), die sich nach einer horizontalen Verschiebungs-Bewegung an den Verankerungs-Mitteln (12) des Informatik-Schranks fixieren, zu ersetzen.
